# EUROPÄISCHE PATENTSCHRIFT

(11) **EP 1 594 692 B1**
(45) Veröffentlichungstag und Bekanntmachung des Hinweises auf die Patenterteilung: **01.06.2011**
(21) Anmeldenummer: 04711981.3
(22) Anmeldetag: 18.02.2004
(51) Int. Cl.: B32B 17/06, B60J 10/02

(54) **SCHEIBENANORDNUNG FÜR EIN FAHRZEUG UND HERSTELLUNGSVERFAHREN DAFÜR**
WINDOW ARRANGEMENT FOR A VEHICLE AND METHOD FOR THE PRODUCTION THEREOF
ENSEMBLE VITRE POUR UN VEHICULE ET PROCEDE DE FABRICATION DUDIT ENSEMBLE

(30) Priorität: 19.02.2003 DE 10306957
(43) Veröffentlichungstag der Anmeldung: 16.11.2005
(73) Patentinhaber: Webasto AG, 82131 Stockdorf (DE)
(72) Erfinder: BOEHM, Hubert, 86926 Greifenberg (DE); ERBECK, Gerit, 85467 Neuching (DE); PÄTZ, Werner, 86928 Hofstetten (DE); TESCHNER, Helmut, 86899 Landsberg/a. Lech (DE); VILSMAYER, Swen, 82152 Krailling (DE)
(74) Vertreter: Schwan - Schwan - Schorer
(86) Internationale Anmeldenummer: PCT/DE2004/000302
(87) Internationale Veröffentlichungsnummer: WO 2004/073976

(56) Entgegenhaltungen:
- EP-A- 1 025 986
- EP-A- 1 310 823
- EP-A- 1 336 520
- WO-A-03/041980
- FR-A- 2 720 328
- US-A- 4 543 283
- US-A- 4 857 376

## Beschreibung

Die vorliegende Erfindung betrifft eine Anordnung zum Verschließen einer Öffnung eines Fahrzeugs, die eine Scheibe und ein mit der Scheibe verbundenes Sptittersehutzelement umfasst, sowie ein Verfahren zur Herstellung einer solchen Anordnung.

Aus der DE 43 231 40 A1 ist eine Scheibenanordnung für einen verstellbaren Deckel eines Fahrzeugdaches bekannt, wobei eine Glasscheibe an ihrer Unterseite mit einer Schicht aus amorphem Silizium versehen ist und im zentralen Bereich der Scheibe eine transparente Polyethylenterphathalat (PET)-Folie mittels einer Klebefolie angebracht ist. Der Randbereich der PET-Folie erstreckt sich in eine Polyurethan-Umschäumung des Deckelrandes hinein, mittels welcher auch ein Deckelinnenblech an der Unterseite der Scheibe angebracht ist.

In der älteren deutschen Patentanmeldung mit dem Aktenzeichen 101 51 156.6 ist ein Glasdeckel für ein Fahrzeugdach beschrieben, wobei eine Scheibe aus Sicherheitsglas mit einer Umschäumung versehen ist, mittels welcher eine Trägeranordnung, z.B. ein Deckelinnenblech, an der Scheibenunterseite angebracht ist. Im zentralen Bereich der Glasscheibe ist an der Scheibenunterseite bzw. an der Unterseite eines an der Scheibenunterseite angebrachten Solarzellenfolienverbunds eine Splitterschutzfolie mittels einer Klebefolie angebracht, wobei die Splitterschutzfolie im Randbereich der Glassscheibe in die Umschäumung eingeschäumt ist oder mechanisch fest mit der Trägeranordnung verbunden ist. Im ersten Fall ist die Splitterschutzfolie im Umfangsrandbereich mit Löchern versehen, um eine gute Verankerung in der Umschäumung zu erzielen.

In der älteren deutschen Patentanmeldung mit dem Aktenzeichen 102 06 717.1 ist ein ähnlicher Glasdeckel beschrieben, wobei ferner ausgeführt ist, dass die Splitterschutzfolie mit einer definierten nicht-glatten Oberflächenstruktur versehen sein kann oder bedruckt oder eingefärbt sein kann, um ein optisch ansprechendes Erscheinungsbild zu erzielen.

In der DE 35 21 115 A1 ist eine Scheibenanordnung für ein Fenster eines Kraftfahrzeugs beschrieben, die eine Glasscheibe mit einer mittels einer elastischen Zwischenschicht aus PVB oder PU an der Scheibe angebrachten Splitterschutzschicht oder Splitterschutzscheibe aus Polyester aufweist, wobei die Scheibe und die an ihr angebrachten Schichten in einen Dichtungsrahmen aus ausgespritztem PU eingebettet sind, der mit der Karosserie verbunden ist.

In der DE 2 247 644 ist eine Windschutzscheibenanordnung für Kraftfahrzeuge beschrieben, welche eine Glasscheibe sowie eine an ihrer Unterseite angebrachte flexible Kunststoffschicht umfaßt, wobei die Kunststoffschicht in ihrem Randbereich mittels einer Kleberaupe mit einem karosseriefesten Rahmen verklebt ist, um die Scheibenanordnung im Rahmen zu halten. Ein direkter Kontakt zwischen der Kleberaupe und der Glasscheibe tritt dabei nicht auf

Aus der US 2,750,312 ist es bekannt, eine zwischen zwei Scheiben angeordnete Kunststofflage in ihrem Randbereich mittels eines Bandes aus verstärktem Gewebematerial mit einem am Rand umlaufenden Rahmen zu verbinden.

Aus der DE 36 32 472 A1 ist eine Kraftfahrzeugscheibenanordnung bekannt, die eine Glasscheibe und eine mittels einer Klebefolie aus PVB an der Unterseite der Glasscheibe angebrachte Splitterschutzfolie aus einer kratzfest beschichteten Polyesterfolie umfaßt, wobei die Scheibe und die beiden Folien gemeinsam in einer angespritzten Rahmendichtung aus PU kraftschlüssig eingefaßt sind, die dazu dient, die Scheibe in einer Karosserieöfnung zu halten. Dabei sind verschiedene Möglichkeiten beschrieben, einen guten Kraftschluß zwischen den Folien und der Rahmendichtung herzustellen. U.a. wird dabei vorgeschlagen, in Bereichen, in welchen die beiden Folien über den Rand der Glasscheibe in die Rahmendichtung hinein überstehen, die Folien durchdringende Löcher vorzusehen, wobei auch die Möglichkeit erwähnt wird, in solche Löcher jeweils einen Hohlniet einzusetzen. Ferner wird dort vorgeschlagen, in dem überstehenden Bereich der Folien auf die PVB-Folie ein Auflageteil aufzukleben. Alternativ wird dort vorgeschlagen, die Folien im überstehenden Randbereich umzubiegen, um für eine Verdickung zu sorgen, oder Einlegeteile bzw. ein U-Profil in den umgeschlagenen überstehenden Randbereich der Folien innerhalb der Rahmendichtung einzulegen.

Die EP 1 025 986 A1 betrifft eine Scheibenanordnung für ein Fahrzeug, wobei an der Unterseite einer Scheibe ein Splitterschutzelement angebracht ist. Die Scheibenanordnung ist mittels einer Kleberaupe an einem Karosserieflansch angeklebt.

Die US 4,543,283 betrifft eine Scheibenanordnung für ein Fahrzeug mit einer Scheibe, an deren Unterseite eine Spiegelschutzfolie angeklebt ist Der Umfangsrand der Glasscheibe und der Folie ist von einem Rahmen aus Elastomermaterial umgeben und die Scheibe wird mit einem Primer-Überzug zwecks verbesserter Haftung versehen.

Die FR 2 720 328 A offenbart eine Scheibenanordnung für ein Fahrzeug, wobei eine Scheibe mit einer Kunststoffolie versehen ist und die Scheibe und die Kunststofffolie am Randbereich der Folie in einen Rahmen eingeklebt werden. Um eine gute Haftung des Klebers mit der Folie zu erzielen, wird der Randbereich der Folie mechanisch beispielsweise mittels Sandstrahlen aufgerauht.

Es ist Aufgabe der vorliegenden Erfindung, eine Anordnung mit einer mit einem Splitterschutzelement versehenen Scheibe zum Verschließen einer Öffnung eines Fahrzeugs zu schaffen, wobei für einen möglichst guten und kostengünstigen Schutz der Fahrzeuginsassen und des Fahrzeuginnenraums bei Bruch der Scheibe gesorgt werden soll. Ferner soll ein entsprechendes Herstellungsverfahren geschaffen werden, welches eine einfache Herstellung einer solchen Anordnung erlaubt.

Diese Aufgabe wird erfindungsgemäß gelöst durch eine Anordnung gemäß Anspruch 1, 2, und 3, sowie entsprechende Herstellungsverfahren gemäß der Ansprüche 36, 37, und 38.

Bei allen Lösungen ist vorteilhaft, dass einerseits bei Bruch der Scheibe die Splitter der gebrochenen Scheibe an dem Splitterschutzelement hängenbleiben, und andererseits dadurch, dass das Splitterschutzelement fest mit dem Halteelement bzw. der Karosserie verbunden ist, das Splitterschutzelement bei gebrochener Scheibe zwar nicht mehr biegesteif ist, aber von dem Halteelement bzw. der Karosserie an Ort und Stelle gehalten wird. Auf diese Weise kann verhindert werden, dass Insassen durch die gebrochene Scheibe nach außen geschleudert werden, Gegenstände und Splitter von außen durch die gebrochene Scheibe in den Innenraum eindringen können oder der Innenraum bei Zerstörung der Scheibe im Falle eines Einbruchs frei zugänglich wird.

Bei der Lösung gemäß Anspruch 1 ist besonders vorteilhaft, dass keine Umschäumung der Scheibe erforderlich ist, so dass die Erfindung auf diese Weise auch für beispielsweise Fahrzeugseitenscheiben oder Fahrzeugwindschutzscheiben verwendet werden kann.

Bei der Lösung gemäß Anspruch 2 ist besonders vorteilhaft, dass auch ohne aufwändige Perforation des Splitterschutzelements für eine hinreichende Haftung zwischen dem Splitterschutzelement und dem Halteelement gesorgt wird, indem die Oberfläche Splitterschutzelements entsprechend bearbeitet wird.

Bei der Lösung gemäß Anspruch 3 ist besonders vorteilhaft, dass verschiedene Alternativen für eine Oberflächengestaltung des Splitterschutzelements geschaffen werden, um eine gute Haftung zwischen dem Splitterschutzelement und dem Halteelement bzw. der Karosserie zu erzielen.

Bevorzugte Ausgestaltungen der Erfindung ergeben sich aus den Unteransprüchen.

Im Folgenden wird die Erfindung anhand der beigefügten Zeichnungen beispielhaft näher erläutert. Dabei zeigen:
- Fig.: 1 eine Querschnittansicht des Randbereichs einer erfibdungsgemäßen Scheibenanordnung gemäß einer ersten Ausführungsform;
- Fig. 2: eine Ansicht wie Fig. 1 einer zweiten Ausführungsform der Erfindung;
- Fig.3: eine vergrößerte Schnittansicht eines beispielhaften Schichtaufbaus einer erfindungsgemäBen Scheibenanordnung außerhalb des Randbereichs;
- Fig. 4: eine Ansicht wie Fig. 3, wobei jedoch eine abgewandelte Ausfüthrungsform gezeigt ist;
- Fig. 5: ist eine schematische Aufsicht auf eine erfindungsgemäße Scheibenanordnung mit zwei getrennten Splitterschutzelementen;
- Fig. 6: eine Querschnittansicht des linken Randbereichs der Scheibenanordnung von Fig. 5 entlang der Linie A-A von Fig. 5;
- Fig. 7: eine schematische Aufsicht auf einen Teil einer abgewandelten Ausführungsform einer erfindungsgemäßen Scheibenanordnuang;
- Fig. 8: eine Schnittansicht entlang der Linie B-B von Fig. 7;
- Fig.9: eine perspektivische Ansicht, teilweise im Schnitt, eines Teils einer Scheibenanordnung mit einem Verbindungselement, wobei die Unterseite der Scheibenanordnung in der Darstellung von Fig. 9 nach oben zeigt;
- Fig. 10: eine Ansicht ähnlich zu Fig. 9, wobei eine abgewandelte Ausführungsform einer erfindungsgemäßen Scheibenanordnung in teils freigeschnittener Darstellung gezeigt ist;
- Fig. 11: eine vergrößerte Ansicht der Vorderkante des in Fig. 10 mit A markierten Bereichs;
- Fig. 12a - 12c: unterschiedliche Ausführungsformen einer erfindungsgemäßen Scheibenanordnung im Querschnitt, wobei es sich bei allen Ausführungsformen um eine vollflächige Anbringung des Splitterschutzelements an der Scheibe handelt und wobei die Unterseite der Scheibenanordnung in der Darstellung nach oben zeigt;
- Fig. 13a-13c: Ansichten wie Fig. 12a bis 12c, wobei abgewandelte Ausführungsformen dargestellt sind, bei welchen ein Randbereich des Splitterschutzelements in die Verklebung ragt;
- Fig. 14: eine perspektivische Darstellung einer abgewandelten Ausführungsform einer erfindungsgemäßen Scheibenanordnung, teils in Schnittdarstellung, wobei ein Teil der Verklebung weggeschnitten ist;
- Fig. 15: eine Ansicht wie Fig. 14, wobei eine abgewandelte Ausführungsform gezeigt ist;
- Fig. 16: eine Ansicht wie Fig. 6, wobei eine abgewandelte Ausführungsform gezeigt ist; und
- Fig. 17: ebenfalls eine Ansicht wie Fig. 6, wobei eine weitere abgewandelte Ausführungsform gezeigt ist.

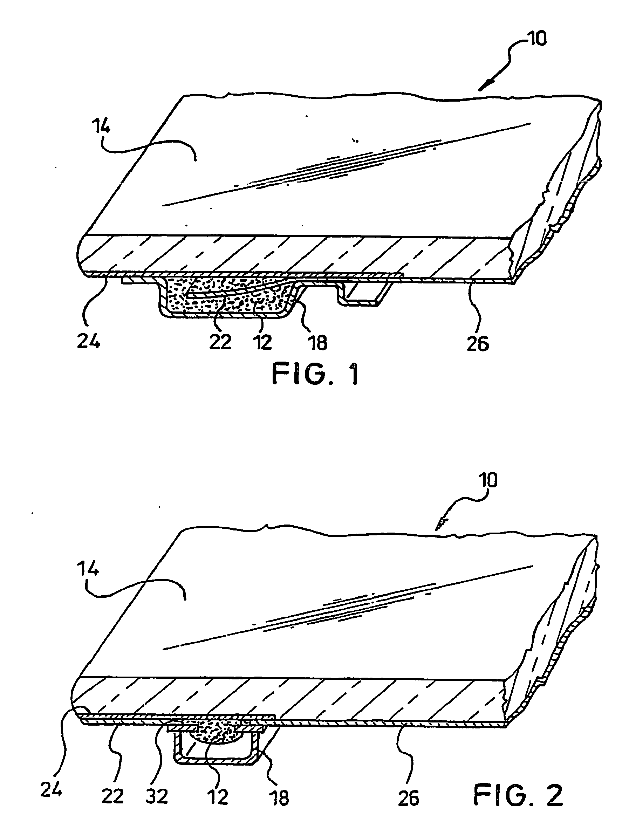

In Fig. 1 ist eine erste Ausführungsform einer Scheibenanordnung 10 gezeigt, bei welcher es sich beispielsweise um eine Windschutzscheibe, Seitenscheibe oder Dachscheibe für ein Kraftfahrzeug, aber auch um eine Scheibe für Schiffe, Boote, Traktoren, Baufahrzeuge und ähnliches handeln kann. Die Scheibenanordnung 10 umfasst eine mindestens teilweise transparente Glasscheibe 14, die vorzugsweise aus thermisch vorgespanntem Einscheibensicherheitsglas ausgebildet ist Im Umfangsrandbereich ist die Scheibe 14 an ihrer zum Fahrzeuginnenraum hinweisenden Seite mit einem Halteelement 18 versehen, welches seinerseits mit der Fahrzeugkarosserie verbunden ist. Das Halteelement 18 kann dabei starr oder beweglich mit der Fahrzeugkarosserie verbunden sein, so dass im letzteren Fall die Scheibenanordnung 10 insgesamt verstellbar ist, um die von der Scheibenanordnung 10 verschlossene Öffnung in der Fahrzeugkarosserie wahlweise mindestens teilweise freizulegen. Die Scheibe 14 ist in ihrem Umfangsrandbereich an der zum Fahrzeuginnenraum hinweisenden Seite mittels einer Verklebung bzw. Klebeverbindung 12 fest mit dem Halteelement 18 verbunden und ist somit über das Halteelement 18 auch mit der Fahrzeugkarosserie verbunden. An der zum Fahrzeuginnenraum hinweisenden Seite der Glasscheibe 14 kann eine Glasfritte 24 vorgesehen sein, um als nicht-transparenter Sichtschutz und Haftfläche zu dienen, um die Verklebung 12 und das Halteelement 18 von außen abzudecken.

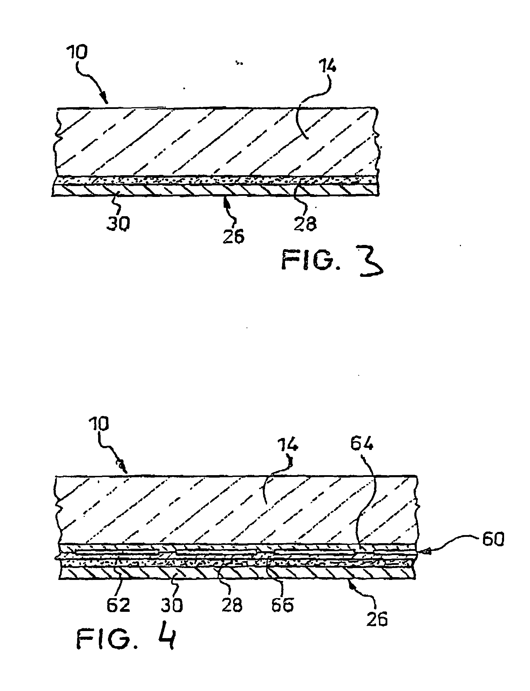

In ihrem zentralen, transparenten Bereich ist die Scheibe 14 an ihrer zum Fahrzeuginnenraum hinweisenden Seite mit einem Schutzfolienverbund 26 laminiert bzw. verklebt, wobei sich dieser Bereich bis in den Bereich der Glasfritte 24 hinein erstreckt Der Schutzfolienverbund 26 ist an seiner der Scheibe 14 zugewandten Seite mit einer Klebefolie bzw. Klebeschicht 28 versehen, welche dazu dient, eine Schutzfolie 30, die reißfest und kratzfest ausgebildet ist, mit der Scheibe 14 zu verkleben. Ein solcher Schichtaufbau ist beispielhaft in Fig. 3 dargestellt. Bei der Klebefolie 28 kann es sich bei allen Ausführungsformen beispielsweise um einen Poly(Vinylbutyral)-Film (PVB-Film), eine transparente Folie aus thermoplastischem Polyurethan (PTU) oder um eine Folie aus Ethylenvinylacetat-copolymer (EVA) handeln, während es sich bei der Schutzfolie 30 bei allen Ausführungsformen vorzugsweise um eine kratzfest beschichtete Kunststoffolie, beispielsweise eine mit Polysiloxanen oder Acrylatlacken beschichtete optische Poly(Ethylenterephthalat)-Folie (PET-Folie) oder eine Polycarbonat-Folie (PC-Folie) handeln kann.

In seinem Umfangsrandbereich 22 erstreckt sich der Schutzfolienverbund 26 in die Verklebung 12 hinein, wobei er zumindest teilweise in die Verklebung 12 eingebettet ist bzw. in diese eintaucht; d.h. in diesem Bereich liegt der Schutzfolienverbund 26 nicht an der Scheibe 14 an. Der Umfangsrandbereich 22 sowie ein Teil des zentralen Bereichs des Schutzfolienverbunds 26 liegen zwischen dem Halteelement 18 und der Scheibe 14. Im nicht an der Scheibe 14 anliegenden Randbereich 22 des Schutzfolienverbunds 26 kann die Klebefolie bzw. Klebeschicht 28 fehlen.

Die Verklebung 12 dient somit nicht nur dazu, das Halteelement 18 mit der Scheibe 14 zu verbinden, sondern dient ferner dazu, den Schutzfolienverbund 26 mit dem Halteelement 18 fest zu verbinden. Auf diese Weise kann sichergestellt werden, dass auch bei Bruch der Glasscheibe 14 eine gewisse mechanische Integrität der Scheibenanordnung 10 erhalten bleibt, indem der Schutzfolienverbund 26 auch bei zerbrochener Scheibe 14 in seinem Randbereich mittels des Halteelements 18, welches seinerseits mit der Fahrzeugkarosserie verbunden ist, aufgespannt bleibt. Dabei verliert der Schutzfolienverbund 26 zwar seine Biegesteifigkeit, verbleibt jedoch bezüglich des Halteelements 18 an Ort und Stelle, wodurch verhindert werden kann, dass einerseits Insassen durch die zerbrochene Scheibe 14 nach außen geschleudert werden und dass andererseits Splitter der Scheibe oder Gegenstände von außen in den Fahrzeuginnenraum eindringen können. Ferner sorgt der Schutzfolienverbund 26 im Falle mutwilliger Zerstörung der Glasscheibe 14 auch für einen gewissen Einbruchsschutz. Die Splitter der zerbrochenen Glasscheibe 14 bleiben aufgrund der Klebeschicht 28 an dem Schutzfolienverbund 26, d.h. der Schutzfolie 30, hängen. Auf diese Weise wirkt die Schutzfolie 30 als Splitterschutzfolie.

In Fig. 4 ist ein zu Fig. 3 alternativer Schichtaufbau der Scheibenanordnung 10 gezeigt, wobei der Schutzfolienverbund 26 nicht direkt an der Glasscheibe 14 angeklebt ist, sondern ein Solarzellenfolienverbund 60 zwischen der Scheibe 14 und der Klebefolie bzw. Klebeschicht 28 des Schutzfolienverbunds 26 vorgesehen ist. Der Solarzellenfolienverbund 60 weist eine Mehrzahl von elektrisch miteinander verbundenen Solarzellen 62 auf, die zwischen zwei Schmelzklebefolien 64 und 66, die vorzugsweise aus EVA bestehen, eingebettet sind. Die Schmelzklebefolie 64 dient dazu, den Solarzellenfolienverbund 60 mit der Glasscheibe 14 zu verbinden, während die Schmelzklebefolie 66 dazu dient, den Schutzfolienverbund 26 mit dem Solarzellenfolienverbund 60 und damit mit der Glasscheibe 14 zu verbinden.

Optional kann die Schmelzklebefolie 66 entfallen, so dass dann die Klebefolie 28 dazu dient, die Splitterschutzfolie 30 direkt mit den Solarzellen 62 bzw. der Schmelzklebefolie 64 zu verbinden.

Vorzugsweise erstreckt sich der Solarzellenfolienverbund 60 nicht bis in den Randbereich 22 des Schutzfolienverbunds 26.

In Fig. 2 ist eine abgewandelte Ausführungsform der Scheibenanordnung 10 von Fig. 1 gezeigt, wobei im Gegensatz zu Fig. 1 nicht nur der zentrale Bereich, sondern auch der Umfangsrandbereich 22 des Schutzfolienverbunds 26 mit der Scheibe 14 verklebt ist, d.h. in diesem Fall ist die Verklebung zwischen der Scheibe 14 und dem Schutzfolienverbund 26 vollflächig ausgebildet. Mit einer vollflächig an der Scheibe 14 angebrachten Splitterschutzfolie 30 ist also eine Anordnung bezeichnet, bei welcher die Splitterschutzfolie 30 bzw. der Folienverbund 26 über die gesamte Fläche flach mit der Scheibe verklebt ist. Um dennoch eine Verklebung des Halteelements 18 mit der Scheibe 14 zu erzielen, ist der Umfangsrandbereich 22 des Schutzfolienverbunds 26 mit Öffnungen 32 versehen, durch welche sich die Verklebung 12 bis zur Scheibe 14 hindurch erstreckt, um eine feste Verbindung zwischen der Scheibe 14 und dem Halteelement 18 zu bewirken. Der Schutzfolienverbund 26 liegt dabei zwischen der Scheibe 14 und dem Halteelement 18, so dass mittels der Öffnungen 32 auch eine Klebeverbindung zwischen dem Schutzfolienverbund 26 und dem Halteelement 18 erzielt wird. Auf diese Weise kann die Herstellung der Scheibenanordnung 10 besonders einfach gestaltet werden, indem der Schutzfolienverbund 26 vollflächig auf die Scheibe 14 aufgebracht wird und dennoch eine direkte Klebeverbindung 12 zwischen der Scheibe 14 und dem Halteelement 18 erzielt wird.

Der zentrale Bereich des Schutzfolienverbunds 26 kann wie bei der Ausführungsform von Fig. 1 entweder direkt oder unter Zwischenschaltung eines Solarzellenfolienverbunds 60 an der Scheibe 14 angebracht sein, siehe Fig. 3 bzw. Fig. 4.

Bei dem Halteelement 18 kann es sich bei beiden Ausführungsformen beispielsweise um einen Verstärkungs- bzw. Trägerrahmen oder, falls es sich bei der Scheibenanordnung 10 um einen Glasdeckel für ein Fahrzeugdach handelt, um ein sogenanntes Deckelinnenblech handeln.

Die Verklebung 12 wird bei beiden Ausführungsformen vorzugsweise erzeugt, indem eine Kleberaupe auf einen der Klebepartner aufgebracht und anschließend die beiden Klebepartner zusammengefügt bzw. zusammengedrückt werden. Die Verklebung 12 ist, beispielsweise im Gegensatz zu einer Umschäumung, dauerelastisch ausgebildet.,. wobei die Shore A-Härte (DIN 53505) vorzugsweise zwischen 30 und 70, die Zugfestigkeit (DIN 53504) vorzugswise zwischen 1 und 10 N/mm² und die Reissdehnung (DIN 53504) vorzugsweise zwischen 300 und 600 % liegt. Als Klebstoff kommen z.B. Silikonkleber bzw. Kleber auf PU-Basis in Frage.

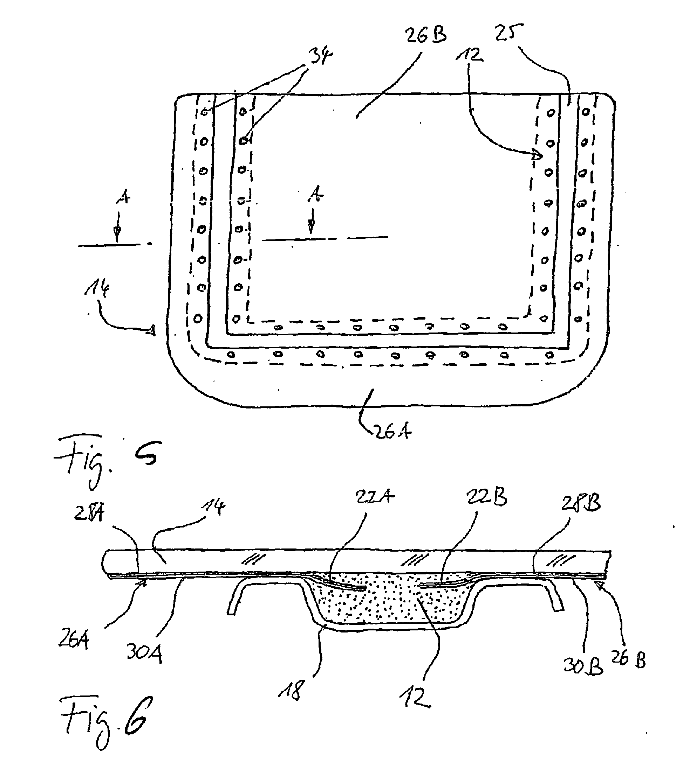

In den Fig. 5 und 6 ist eine Ausführungsform gezeigt, bei welcher, im Gegensatz zu den bisher diskutierten Ausführungsformen, nicht eine einzige, sondern zwei durch eine Unterbrechung 25 voneinander getrennte Schutzfolienverbünde 26A und 26B vorgesehen sind, die jeweils eine Klebefolie 28A bzw. 28B und eine Splitterschutzfolie 30A bzw. 30B aufweisen. Die beiden Folienverbünde 26A und 26B sind flächig nebeneinander angebracht, wobei der Folienverbund 26B bezüglich der Scheibenmitte innen liegt, während der Schutzfolienverbund 26A den Folienverbund 26B - getrennt durch eine Unterbrechung 25-ringartig umgibt. Beide Folienverbünde 26A, 26B sind in ihrem zu der Unterbrechung 25 hin weisenden Randbereich mit Löchern 34 versehen, um die Haftung in einer gemeinsamen Verklebung 12, mittels welcher ferner auch ein Halteelement 18 an der Scheibenunterseite angeklebt ist, zu verbessern. Gemäß Fig. 6 sind dabei die jeweiligen zu der Unterbrechung 25 hin weisenden Randbereiche 22A bzw. 22B bezüglich der Unterseite der Glasscheibe 14 frei, d.h. sie ragen frei in die Verklebung 12 hinein. In Fig. 5 ist die gemeinsame Verklebung 12 der Folienverbünde 26A, 26B mit gestrichelten Linien angedeutet.

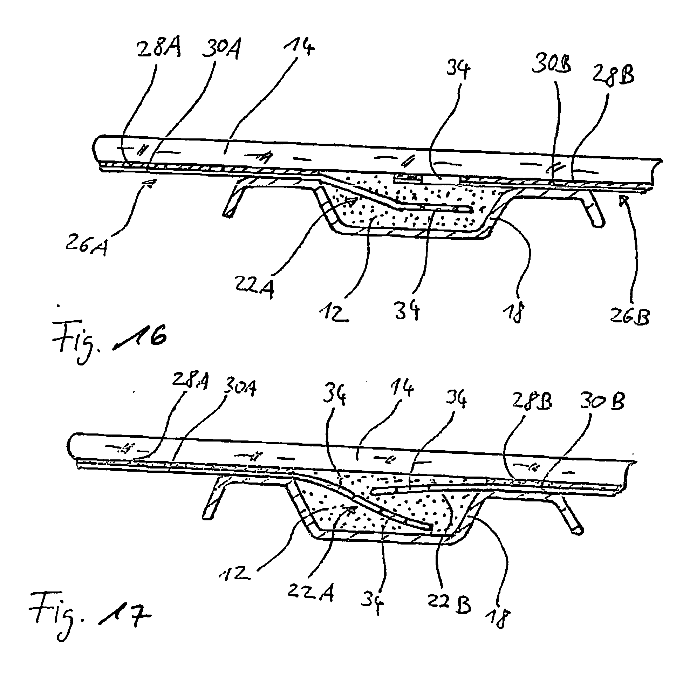

In den Fign. 16 und 17 ist jeweils eine Abwandlung zur Ausführungsform von Fig. 6 gezeigt, wobei die beiden Splitterschutzfolien 30A und 30B in beiden Fällen im Bereich der gemeinsamen Verklebung 12 überlappen bzw. einander vertikal verschoben teilweise überdecken; d.h. hier ist im Gegensatz zur Ausführungsform von Fign. 5 und 6 keine sich horizontale erstreckende Unterbrechung 25 ausgebildet, sondern die Trennung erfolgt in vertikaler Richtung.

Bei der Ausführungsform von Fig. 16 ist die rechte Splitterschutzfolie 30B vollflächig mittels der Schmelzklebefolie an der Scheibe 14 angebracht, wobei in dem sich in die Verklebung 12 erstreckenden Bereich der Folien 28 und 30 Löcher 34 für den Durchtritt von Kleber auf die Scheibe 14 vorgesehen sind, während die linke Splitterschutzfolie 30A in ihrem sich in die Verklebung 12 erstreckenden Randbereich 22A von der Scheibe 14 frei ist und absteht, wobei ebenfalls zur besseren Verankerung Löcher 34 vorgesehen sind.

Bei der Ausführungsform von Fig. 17 sind beide Splitterschutzfolien 30A, 30B in ihrem sich in die Verklebung 12 erstreckenden Randbereich 22A, 22B von der Scheibe 14 frei sind und abstehen. Auch hier sind beide Randbereiche 22A, 22B mit Löchern 34 zur besseren Verankerung in der Verklebung 12 versehen.

Bei beiden Ausführungsformen sind die von der Scheibe 14 freien Randbereiche der Splitterschutzfolien 30A, 30B nicht mit der Schmelzklebefolie 28A, 28B versehen.

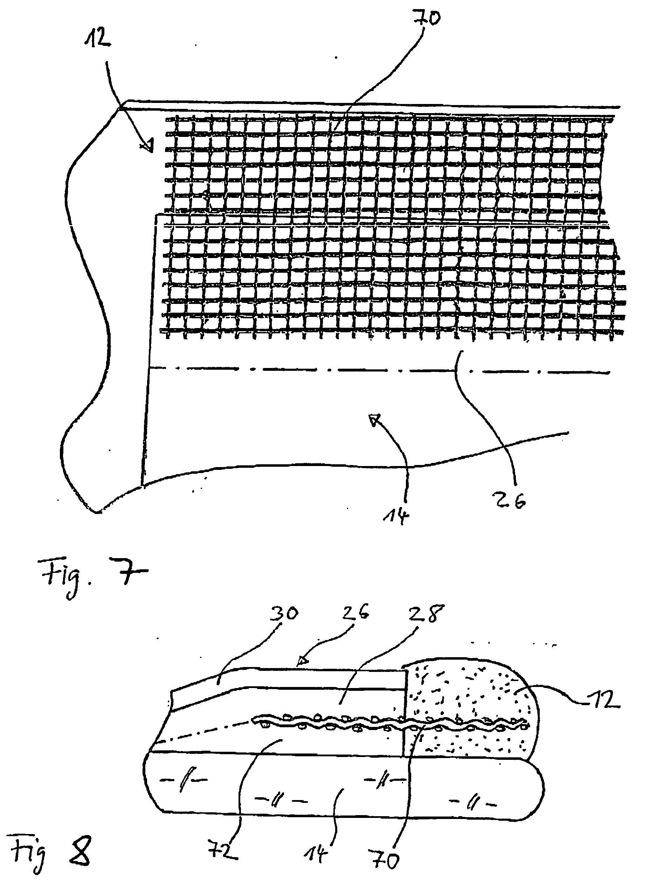

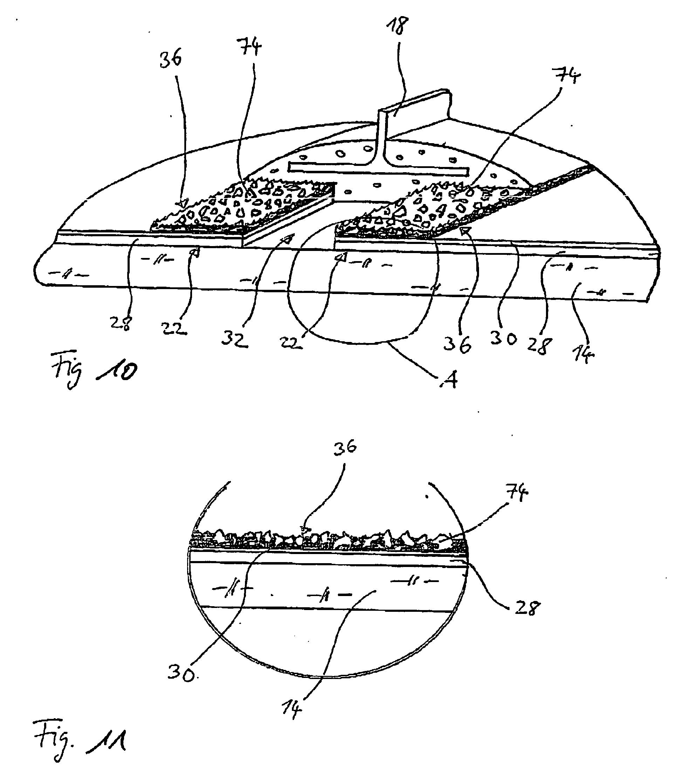

In den Fig. 7 und 8 ist eine abgewandelte Ausführungsform einer Scheibenanordnung gezeigt, bei welcher die Anbindung des Schutzfolienverbunds 26 mit der Verklebung des Halteelements 18 nicht direkt erfolgt, sondern über ein flächiges Verbindungselement 70. Dabei wird er Kraftschluß zwischen dem Schutzfolienverbund 26 und der Verklebung 12, welche mit einem in den Fig. 7 und 10 nicht gezeigten Halteelement verbunden ist, nicht durch einen direkten Kontakt zwischen dem Schutzfolienverbund 26 und der Verklebung 12, sondern indirekt über das Verbindungselement 70 hergestellt, welches dabei als Haftbrücke wirkt. Bei dem in Fig. 7 und 8 gezeigten Ausführungsbeispiel ist das Verbindungselement 70 als Streifen ausgebildet, der im Randbereich der Scheibe 14 mit der zur Scheibenmitte hin weisenden Hälfte zwischen die an der Oberseite der Splitterschutzfolie 30 vorgesehene Schmelzklebefolie 28 und einen zusätzlichen Streifen 72 aus Schmelzklebefolie eingelegt ist, wobei der Streifen 72 auf der Unterseite der Scheibe 14 aufliegt. Die zum Scheibenrand hin weisende Hälfte des Verbindungselement 70 ragt dagegen in die Verklebung 12 hinein.

Das Verbindungselement 70 ist flächig ausgebildet und wird vorzugsweise von einem Gewebe aus beispielsweise Kunststoff oder Metall gebildet, wobei die Maschenweite entsprechend der Viskosität des Klebers der Verklebung 12 unterschiedlich groß gewählt sein, um ein Durchdringen der Poren des Gewebes mit dem Verklebungslnaterial zu ermöglichen. Das Verbindungselement 70 kann im gesamten Umfangsrandbereich des Folienverbunds 26 oder nur in Abschnitten desselben vorgesehen sein.

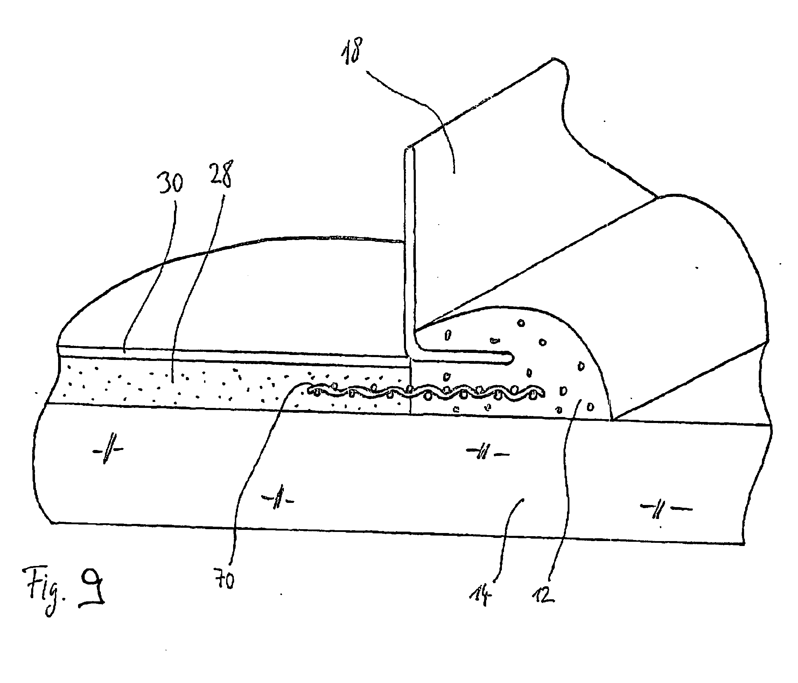

In Fig. 9 ist eine Abwandlung der Ausführungsform von Fig. 7 und 8 gezeigt, wobei ein als Winkel ausgebildetes Halteelement 18 dargestellt ist, welches in die Kleberaupe 12 zusammen mit dem Verbindungselement bzw. Verbindungsgewebe 70 eingeklebt ist und auf diese Weise mit der Unterseite der Scheibe 14 fest verbunden ist. Das Halteelement 18 dient zur Anbindung der Scheibe 14 an die Fahrzeugkarosserie.

In den Fign. 10 und 11 ist eine Ausführungsform gezeigt, wobei die Oberfläche der Splitterschutzfolie 30 im Randbereich 22 mit einem Primersystem 36 versehen ist, um die Haftung zu einer Verklebung 12 zu verbessern. Das Primersystem 36 ist an seiner von der Splitterschutzfolie 30 weg weisenden Oberfläche mit Füllpartikeln 74 angereichert wurde, um eine noch bessere Haftung zwischen dem Randbereich 22 der Splitterschutzfolie 30 und der Verklebung 12 zu erzielen. Bei diesen Füllpartikeln 24 kann es sich beispielsweise um Quarzsand oder Kunststoffpartikel (Kunststoffschnipsel) handeln, wobei die durchschnittliche Teilchengröße vorzugsweise im Bereich von 0,1 bis 1,0 mm liegt.

Ferner ist in Fig. 10 die Splitterschutzfolie 30 im Randbereich 22 mit dem Primersystem 36 mit einer Aussparung 32 versehen, durch welche diese Verklebung 12 in direkten Kontakt mit der Unterseite der Scheibe 14 kommen kann. Eine ähnliche Aussparung ist auch in der Ausführungsform von Fig. 2 dargestellt. Grundsätzlich könnte die Aussparung 32 in Analogie zur Ausführungsform gemäß Fig. 5 und 6 als um einen Teil der Splitterschutzfolie 30 umlaufend ausgebildet sein, wobei auf diese Weise zwei getrennte Splitterschutzfolien mittels einer einzigen Verklebung an ein Halteelement 18 angebunden werden können, wobei dieses Halteelement 18 in der Darstellung von Fig. 10 ein T-förmiges Querschnittsprofil aufweist und zwecks guter Verankerung in der Verklebung 12 mit seinem horizontalen Abschnitt in die 12 Verklebung eingeklebt bzw. eingeschäumt ist

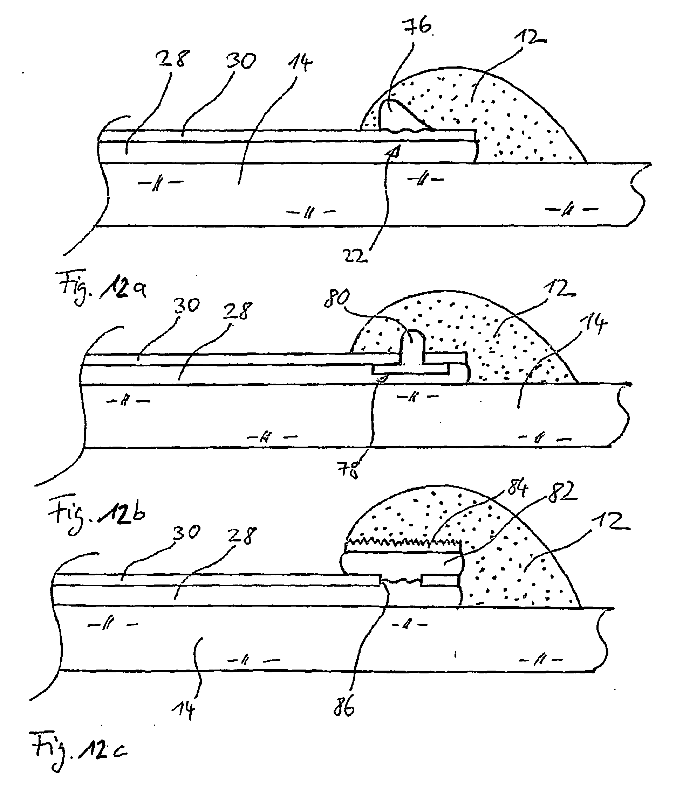

In den Fig. 12a bis 12c sind verschiedene Varianten gezeigt, um bei einer vollflächig verklebten Splitterschutzfolie 30 im Randbereich 22 mittels einer Modifikation der von der Scheibe 14 weg weisenden Oberfläche der Splitterschutzfolie 30 eine verbesserte Haftung in einer Verklebung 12 zu erzielen.

Bei der Ausführungsform von Fig. 12a ist im Randbereich 22 ein Kunststoffprofil 76 auf die von der Scheibe 14 weg weisende Oberfläche der Splitterschutzfolie 30 aufgeschweißt, wobei das Kunststoffprofil 76 in die Verklebung 12 mit eingeklebt ist, um ein Herausreißen der Folie aus der Verklebung 12 möglichst zu verhindern. Das Kunststoffprofil 76 erstreckt sich dabei nach unten in die Verklebung 12 hinein. Bei einer Abwandlung kann das Kunststoffprofil 76 durch ähnlich geformte einzelne separate Elemente ersetzt werden, die ebenfalls auf die Splitterschutzfolie 30 aufgeschweißt sind. In einer anderen Abwandlung der Ausführungsform von Fig. 12a kann das Profil 76 auf die Oberfläche der Splitterschutzfolie 30 aufgeklebt sein statt mit dieser verschweißt zu sein.

In Fig. 12b ist eine abgewandelte Ausführungsform gezeigt, bei welcher ein Kunststoffprofil 78 im Randbereich 22 der Splitterschutzfolie 30 vorgesehen ist, welches zwischen die Splitterschutzfolie und die Schmelzklebefolie 28 bzw. eine entsprechende Kleberschicht eingelegt wurde und mit mehreren Nippeln 80 durch entsprechende Perforationen in der Folie 30 durch diese hindurch und in die Verklebung 12 hineinragt, um eine bessere Haftung der Splitterschutzfolie 30 in der Verklebung 12 zu erzielen. Auch hier könnte statt eines durchgängigen Profils eine Anzahl ähnlicher separater Elemente vorgesehen sein.

Den Ausführungsformen von Fig. 12a und 12b ist gemeinsam, dass hier der Randbereich 22 der Splitterschutzfolie 30 mit einer erhabenen Struktur 76 bzw. 80 versehen wurde, um die Anbindung der Splitterschutzfolie 30 an die Verklebung 12 zu verbessern.

Bei der Ausführungsform gemäß Fig. 12c wird die Verbesserung der Anbindung der Splitterschutzfolie 30 an die Verklebung 12 dadurch erzielt, dass mittels eines Schmelzklebefolienstreifens 82 eine flächige Struktur 84 mit aufgerauhter Oberfläche, bei welcher es sich beispielsweise um einen Gewebestreifen mit aufgeklebten Partikeln handeln kann, auf die von der Scheibe 14 abgewandte Oberfläche der Splitterschutzfolie 30 aufgeklebt wurde, wobei die aufgerauhte Struktur 84 in die Verklebung 12 mit eingeklebt bzw. eingeschäumt ist. Um zusätzlich eine direkte Anbindung des Schmelzklebefolienstreifens 82 an die Schmelzklebefolie 28 und damit die Unterseite der Scheibe 14 zu erzielen, kann die Splitterschutzfolie 30 mit einer Öffnung 86 versehen sein, durch welche der Kontakt zwischen dem Schmelzklebefolienstreifen 82 und der Schmelzklebefolie 28 vermittelt wird.

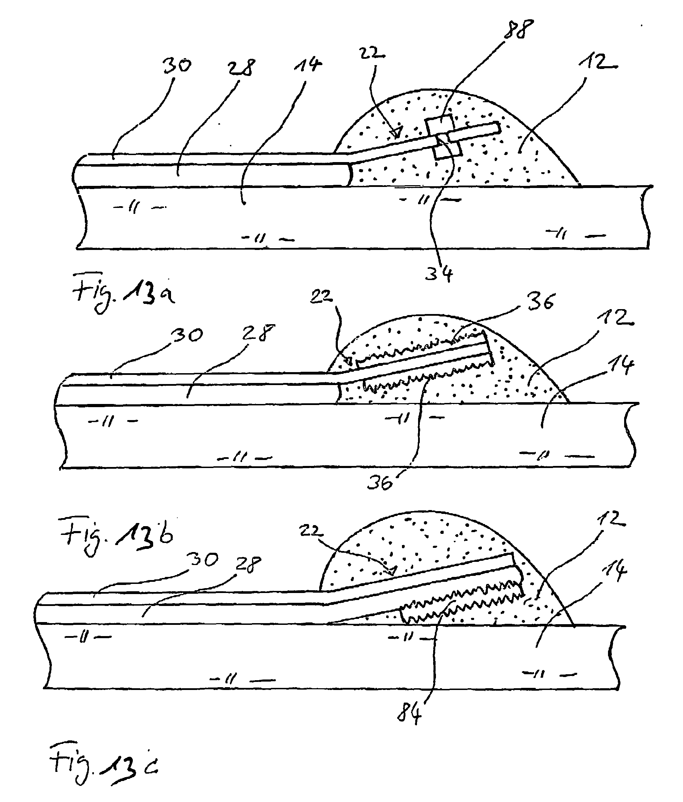

In den Fig. 13a bis 13c sind Ausführungsformen gezeigt, bei welchen der Randbereich 22 der Splitterschutzfolie 30 von der Scheibe 14 frei ist und in eine Verklebung 12 hinein ragt, wobei verschiedene Möglichkeiten zur Erhöhung der Haftung der Splitterschutzfolie 30 in der Verklebung 12 gezeigt sind.

Bei der Ausführungsform gemäß Fig. 13a ist der Randbereich 22 der Splitterschutzfolie 30 mit Löchern 34 versehen, durch welche Elemente 88 durchgesteckt sind, die auf beiden Seiten über die entsprechende Oberfläche der Splitterschutzfolie 30 in die Verklebung 12 hinein ragen. Auf diese Weise kann die Anbindung der Splitterschutzfolie 30 an die Verklebung 12 deutlich verbessert werden. In dem sich in die Verklebung 12 erstreckenden freien Randbereich 22 der Splitterschutzfolie 30 ist keine Schmelzklebefolie 28 vorgesehen.

Bei der Ausführungsform von Fig. 13b ist eine alternative Art der Modifizierung der Oberfläche der Splitterschutzfolie 30 im Randbereich 22 gezeigt, wobei hier beide Oberflächen der Splitterschutzfolie 30 im Randbereich 22 mit einem Primersystem 36 versehen sind, welches Füllpartikel, beispielsweise aus Quarzsand oder Kunststoff, an der jeweils zur Verklebung 12 hin weisenden Seite aufweisen. Auch bei der Ausführungsform von Fig. 13b ist der Randbereich 22 der Splitterschutzfolie 30 nicht mit einer Schmelzklebefolie 28 versehen.

Bei der Ausführungsform von Fig. 13c erstreckt sich dagegen auch die Schmelzklebefolie 28 in den Randbereich 22 der Splitterschutzfolie 30 und dient dazu, eine flächige Struktur 84 mit aufgerauhter Oberfläche mit der zur Scheibe 14 hinweisenden Seite der Splitterschutzfolie 30 zu verbinden, um eine verbesserte Haftung der Splitterschutzfolie 30 in der Verklebung 12 dadurch zu erzielen, dass die aufgerauhte Struktur 84 in Eingriff mit der Verklebung 12 steht.

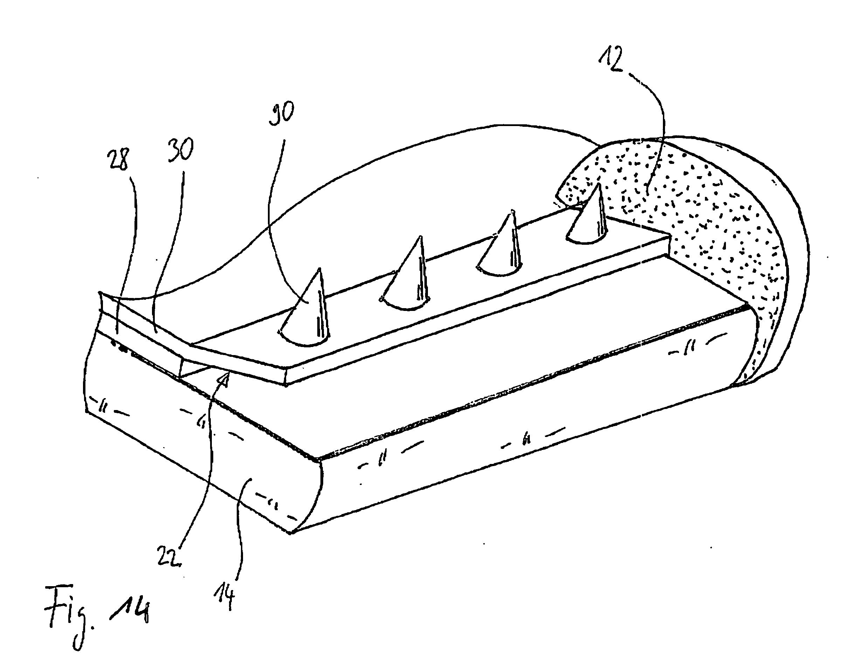

In Fig. 14 ist eine Variante der Ausführungsform von Fig. 13a gezeigt, wobei statt der durch Löcher 34 gesteckten Elemente 88 im Randbereich 22 der Splitterchutzfolie 30 auf die von der Scheibe 14 weg weisende Oberfläche der Splitterschutzfolie 30 aufgeschweißte Kunststoffkegel 90 vorgesehen sind, die mit der Verklebung 12 in Eingriff stehen und auf diese Weise eine verbesserte Haftung der Splitterschutzfolie 30 in der Verklebung 12 bewirken.

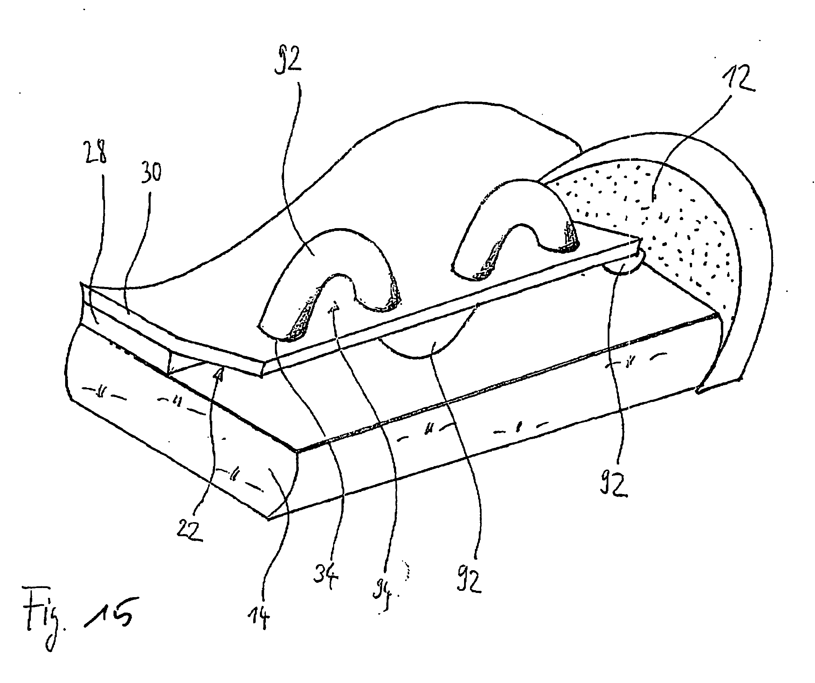

In Fig. 15 ist eine weitere Abwandlung der Ausführungsformen von Fig. 13a-c und Fig. 14 gezeigt, wobei im Randbereich 20 der Splitterschutzfolie 30 mehrere hintereinander entlang der Verklebung 12 angeordnete Löcher 34 in der Splitterschutzfolie 30 vorgesehen sind, durch welche eine langgestreckte Struktur 92, bei der es sich vorzugsweise um einen Faden oder eine Schnur handelt, alternierend durchgefädelt ist, wobei die Struktur 92 auf beiden Seiten der Splitterschutzfolie 30 Ösen 94 bildet. Vorzugsweise ist die langgestreckte Struktur 92 aus Kunststoff ausgebildet Es können auch mehrere solcher Strukturen 92 nebeneinander vorgesehen sein. Die Struktur 92 verläuft innerhalb der Verklebung 12 und steht dadurch mit dieser so in Eingriff, dass eine Verbesserung der Anbindung der Splitterschutzfolie an die Verklebung 12 erzielt wird.

Grundsätzlich kann bei allen beschriebenen Ausführungsformen als Splitterschutzelement statt einer Splitterschutzfolie eine Splitterschutzplatte verwendet werden, wobei sich diese beiden Varianten im wesentlichen über die Biegeelastizität und damit bei vorgegebenem Material über die Schichtdicke des Splitterschutzelements unterscheiden.

Ferner kann die Verklebung allgemein statt zur Anbindung des Splitterschutzelements an ein mit der Fahrzeugkarosserie verbundenes Halteelement alternativ auch zur direkten Anbindung des Splitterschutzelements an die Fahrzeugkarosserie dienen. Es versteht sich, dass bei allen gezeigten Ausführungsformen die Verklebung mit der Fahrzeugkarosserie oder einem mit der Fahrzeugkarosserie verbundenen Halteelement verbunden ist, auch wenn dies nicht in allen Figuren dargestellt ist.

Bei allen gezeigten Ausführungsformen dient die Verklebung gleichzeitig sowohl zur Anbindung des Splitterschutzelements an ein Halteelement (b2w. die Fahrzeugkarosserie) als auch zur Anbindung der Scheibe an das Halteelement (bzw. die Fahrzeugkarosserie). Grundsätzlich sind jedoch auch Ausführungsformen denkbar, bei welchen die Verklebung ausschließlich der Anbindung des Splitterschutzelements an ein Halteelement bzw. an die Fahrzeugkarosserie dient, wobei die Scheibe dann entweder separat an das Halteelement bzw. die Fahrzeugkarosserie angebunden ist oder dies indirekt über die Anbindung des Splitterschutzelements erfolgt.

Es versteht sich ferner, dass obschon bei den meisten gezeigten Ausführungsformen nur ein einzelnes Splitterschutzelement gezeigt ist, grundsätzlich mehrere flächig nebeneinander angeordnete Splitterschutzelemente für die Scheibe vorgesehen sein können.

Grundsätzlich kann die Anbindung des Splitterschutzelements an das Halteelement bzw. die Fahneugkarosserie mittels der Verklebung im Randbereich des Splitterschutzelements und der Scheibe erfolgen (dies ist in Regelfall am zweckmäßigsten), alternativ jedoch aber auch in einem weiter innen liegenden Bereich der Scheibe und/oder des Splitterschutzelements.

Allgemein kann die Anbindung des Splitterschutzelements an die Verklebung entweder im gesamten Umfangsrandbereich des Splitterschutzelements oder segmentweise nur in Teilbereichen des Umfangsrandbereichs erfolgen.

Um ein verbessertes optisches Erscheinungsbild des Splitterschutzelements aus dem Fahrzeuginnenraum zu erzielen, kann das Splitterschutzelement beispielsweise mit einer definierten, nicht-flachen Oberflächenstruktur versehen sein, wobei beispielsweise eine "genarbte" Struktur mittels einer Matrize hergestellt wird. Solche genarbten Oberflächenstrukturen finden beispielsweise auch bei Armaturentafeloberflächen Verwendung und werden von einem regelmäßigen Muster aus eingedrückten Vertiefungen gebildet. Alternativ kann das Splitterschutzelement mit einem aufgedruckten regelmäßigen Muster versehen sein oder über ihre gesamte Dicke eingefärbt sein. Die Bedruckung kann so ausgebildet sein, dass bestimmte Abschnitte des Solarzellenfolienverbunds, z.B. die Solarzellenverbinder, abgedeckt werden.

Das Splitterschutzelement ist vorzugsweise auf der zum Fahrzeuginnenraum hinweisenden Seite der Scheibe angeordnet, obschon es unter Umständen auch wünschenwert sein könnte, das Splitterschutzelement auf der Außenseite der Scheibe oder sowohl auf der Außenseite als auch der Innenseite der Scheibe vorzusehen.

Vorzugsweise sind sowohl die Scheibe als auch das Splitterschutzelement mindestens teilweise transparent. Es sind jedoch auch Anwendungen denkbar, bei welchen die Scheibe und/oder das Splitterschutzelement undurchsichtig ausgebildet sind. Insbesondere wenn eine Solarzellenfolienverbund vorgesehen ist, kann es zweckmäßig sein, dass das Splitterschutzelement mindestens zum Teil undurchsichtig ausgebildet ist, während die Scheibe transparent ist

### Bezugszeichenliste

- 10, 110: Scheibenanordnung
- 12: Verklebung
- 14: Glasscheibe
- 18: Halteelement
- 20: Dichtungsausnehmung
- 22, 22A, 22B: Randbereich von 26, 26A, 26B
- 24: Glasfritte
- 25: Unterbrechung zwischen 26A und 26B
- 26, 26A, 26B: Splitterschutzfolienverbund
- 28, 28A, 28B: Klebefolie
- 30, 30A, 30B: Splitterschutzfolie
- 32: Öffnungen in 26
- 34: Löcher in 22
- 36: Oberflächenbereich von 22
- 60: Solarzellenfolienverbund
- 62: Solarzellen
- 64, 66: Schmelzklebefolien
- 70: Verbindungselement
- 72: Streifen aus Schmelzklebefolie
- 74: Füllpartikel
- 76: erhabenes Kunststoffprofil
- 78: erhabenes Kunststoffprofil
- 80: Nippel von 78
- 82: Schmelzklebefolienstreifen
- 84: aufgerauhte Struktur
- 86: Öffnung in 30
- 88: durchgestecktes Element
- 90: Kunststoffkegel
- 92: durchgefädelte Struktur
- 94: Ösen

## Patentansprüche

1. Anordnung zum Verschließen einer Öffnung eines Fahrzeugs, mit einer Scheibe (14), wobei an der Scheibe oder an einem an der Scheibe angeordneten Funktionselement (60) ein Splitterschutzelement (30, 30A, 302) angebracht ist, und wobei die Scheibe und das Splitterschutzelement mittels einer dauerelastischen Verklebung (12) mit der Fahzeugkarosserie oder einem mit der Fahrzeugkarosserie verbundenen Halteelement (18) verbunden sind, **dadurch gekennzeichnet, dass** ein Randbereich (22, 22A, 22B) des Splitterschutzelements (30, 30A, 30B) von der Scheibe (14) bzw. dem Funktionselement (60) frei ist und in die Verklebung eintaucht

2. Anordnung nach Anspruch 1, **dadurch gekennzeichnet, dass** die Oberfläche des Splitterschutzelements mit Mitteln (36, 74, 76, 78, 80, 84, 88, 90, 92) versehen ist, um die Haftung zwischen dem Splitterschutselement und der Verklebung zu erhöhen; und dass die Verklebung (12) als Kleberaupe ausgebildet ist.

3. Anordnung zum Verschließen einer Öffnung eines Fahrzeugs, mit einer Scheibe (14), wobei an der Scheibe oder an einem an der Scheibe angeordneten Funktionselement (60) ein Splitterschutzelement (30) angebracht ist, wobei die Scheibe und das Splitterschutzelement mittels einer dauerelastischen Verklebung (12) mit der Fahrzeugkarosserie oder einem mit der Fahrzeugkaresserie verbundenen Halteelement (18) verbunden ist, **dadurch gekennzeichnet, dass** beide Oberflächen des Splitterschutzelements (30) mit einer durch Öffnungen (34) in dem Splitterschutzelement alternierend durchgefädelten, auf beiden Seiten des Splitterschutzelements Ösen (94) bildenden, langgestreckten Struktur (92) versehen sind, um die Haftung zwischen dem Splitterschutzelement und der Verklebung zu erhöhen.

4. Anordnung nach einem der Ansprüche 1 bis 3, **dadurch gekennzeichnet, dass** die dauerelastische Verklebung (12) im Randbereich (22, 22A, 22B) des Splitterschutzelements (30, 30A, 30B) vorgesehen ist

5. Anordnung nach Anspruch 3, **dadurch gekennzeichnet, dass** die langgestreckte Struktur (92) im Randbereich (22) des Splitterschutzelements (30) vorgesehen sind.

6. Anordnung nach Anspruch 2, **dadurch gekennzeichnet, dass** es sich bei den Mitteln zur Haftungserhöhung um eine mechanische Oberflächenaufrauhung (36) des Splitterschutzelements handelt.

7. Anordnung nach Anspruch 2, **dadurch gekennzeichnet, dass** es sich bei den Mitteln zur Haftungserhöhung um eine auf die von der Scheibe (14) abgewandte Oberfläche des Splitterschutzelements (30) aufgebrachte erhabene Struktur (76, 80, 88, 90) handelt.

8. Anordnung nach Anspruch 7, **dadurch gekennzeichnet, dass** die erhabene Struktur (76, 80, 88, 90) aufgeschweißt, aufgeklebt oder durch Öffnungen (34) von der der Scheibe (14) zugewandten Seite des Splitterschutzelements (30) aus durchgesteckt ist.

9. Anordnung nach Anspruch 7 oder 8, **dadurch gekennzeichnet, dass** die erhabene Struktur von einem in die Verklebung (12) ragenden Profil (76, 78) oder von einzelnen in die Verklebung ragenden Elementen (90) gebildet wird.

10. Anordnung nach Anspruch 9, **dadurch gekennzeichnet, dass** die erhabene Struktur in die Verklebung (12) ragende Nippel (80) oder Kegel (90) aufweist.

11. Anordnung nach Anspruch 2, **dadurch gekennzeichnet, dass** es sich bei den Mitteln zur Haflungserhöhung um eine auf die von der Scheibe abgewandte Oberfläche des Splitterschutzelements (30) aufgebrachte Struktur (84) mit einer aufgerauhten Oberfläche handelt.

12. Anordnung nach Anspruch 11, **dadurch gekennzeichnet, dass** die Struktur (84) mit der aufgerauhten Oberfläche mittels einer Schmelzklebefolie (28, 82) auf das Splitterschutzelement (30) aufgeklebt ist.

13. Anordnung nach Anspruch 2, **dadurch gekennzeichnet, dass** es sich bei den Mitteln zur Haftungserhöhung um ein an der Oberfläche des Splitterschutzelements (30) aufgebrachtes Primersystem (36) handelt.

14. Anordnung nach Anspruch 13, **dadurch gekennzeichnet, dass** an der von dem Splitterschutzelement (30) abgewandten Seite des Primersystems (36) das Primersystem mit Füllpartikeln (74) angereichert ist

15. Anordnung nach Anspruch 14, **dadurch gekennzeichnet, dass** es sich bei den Füllpartikeln (74) um Quarzsand oder Kunststoffpartikel handelt.

16. Anordnung nach Anspruch 14 oder 15, **dadurch gekennzeichnet, dass** die Füllpartikel eine durchschnittliche Teilchengröße von 0,1 bis 1,0 mm haben.

17. Anordnung nach einem der vorhergehenden Ansprüche, **dadurch gekennzeichnet, dass** das Splitterschutzelement (30) mindestens in einem Teilbereich des Halteelements (18) zwischen dem Halteelement und der Scheibe (14) liegt.

18. Anordnung nach Anspruch 2, **dadurch gekennzeichnet, dass** Mittel bzw. die Mittel (36, 74, 84, 88, 92) zur Haftungserhöhung im freien Randbereich (22) des Splitterschutzelements (30) vorgesehen sind.

19. Anordnung nach einem der vorhergehenden Ansprüche, **dadurch gekennzeichnet, dass** das Splitterschutzelement (30, 30A, 30B)) in seinem gesamten Umfangsrandbereich oder nur in Teilen bzw. Segmenten seines Umfangsrandbereichs mit der Verklebung (12) verbunden ist.

20. Anordnung nach einem der vorhergehenden Ansprüche, **dadurch gekennzeichnet, dass** das Splitterschutzelement (30, 30A, 30B) als elastische Folie oder als starre Platte ausgebildet ist.

21. Anordnung nach einem der vorhergehenden Ansprüche, **dadurch gekennzeichnet, dass** die dauerelastische Verklebung (12) im Randbereich der Scheibe (14) vorgesehen ist.

22. Anordnung nach einem der vorhergehenden Ansprüche, **dadurch gekennzeichnet, dass** die dauerelastische Verklebung (12) eine Shore A-Härte von 30 bis 70 und/oder eine Zugfestigkeit von 1 bis 10 N/mm² und/oder eine Reißdehnung von 300 bis 600 % aufweist.

23. Anordnung nach einem der vorhergehenden Ansprüche 1 oder 3, **dadurch gekennzeichnet, dass** die Verklebung (12) als Kleberaupe ausgebildet ist.

24. Anordnung nach einem der vorhergehenden Ansprüche, **dadurch gekennzeichnet, dass** es sich bei dem Funktionselement um einen Solarzellenverbund (60) handelt.

25. Anordnung nach einem der vorhergehenden Ansprüche 1 oder 3, **dadurch gekennzeichnet, dass** es sich bei dem Halteelement (18) um einen Verstarkungsrahmen handelt.

26. Anordnung nach einem der vorhergehenden Ansprüche, **dadurch gekennzeichnet, dass** die Anordnung (10, 110) einen Glasdeckel für eine Dachöffnung bildet.

27. Anordnung nach Anspruch 25, **dadurch gekennzeichnet, dass** es sich bei dem Halteelement (18) um ein Deckelinnenblech handelt.

28. Anordnung nach einem der vorhergehenden Ansprüche, **dadurch gekennzeichnet, dass** das Splitterschutzelement (30) mittels einer Klebefolie (28) oder einer verpressten Klebstofflage an der Glasscheibe (14) bzw. dem Funktionselement (60) angebracht ist.

29. Anordnung nach einem der vorhergehenden Ansprüche, **dadurch gekennzeichnet, dass** die Scheibe (14) aus Sicherheitsglas gefertigt ist.

30. Anordnung nach Anspruch 18, **dadurch gekennzeichnet, dass** es sich bei den Mitteln zur Haftungserhöhung um ein auf der der Scheibe (14) zugewandten Oberfläche des Splitterschutzelements (30) oder auf beiden Oberflächen des Splitterschutzelements aufgebrachtes Primersystem (36) handelt.

31. Anordnung nach Anspruch 18, **dadurch gekennzeichnet, dass** es sich bei den Mitteln zur Haftungserhöhung um eine auf die der Scheibe (14) zugewandte Oberfläche des Splitterschutzelements (30) oder auf beide Oberflächen des Splitterschutzelements aufgebrachte erhabene Struktur (88, 90 92) handelt.

32. Anordnung nach Anspruch 31 **dadurch gekennzeichnet, dass** die erhabene Struktur von durch Öffnungen (34) in dem Splitterschutzelement (30) durchgesteckte und auf mindestens einer Seite des Splitterschutzelements herausragende Elemente (88) gebildet wird.

33. Anordnung nach Anspruch 32, **dadurch gekennzeichnet, dass** es sich bei den durchgesteckten Elementen um mindestens eine durch Öffnungen (34) in dem Splitterschutzelement (30) alternierend durchgefädelte, langgestreckte Struktur (92), insbesondere einen Faden oder eine Schnur, handelt.

34. Anordnung nach Anspruch 33, **dadurch gekennzeichnet, dass** die langgestreckte Struktur (92) auf beiden Seiten des Splitterschutzelements (30) Ösen (94) bildet

35. Anordnung nach Anspruch 18, **dadurch gekennzeichnet, dass** das Splitterschutzelement (30) mittels einer Schmelzklebefolie (28) mit der Scheibe verbunden ist, wobei sich die Schmelzklebefolie in den freien Randbereich (22) des Splitterschutzelements (30) hineinstreckt und zur Anbringung der Mittel (84) zur Haftungserhöhung an der der Scheibe (14) zugewandten Oberfläche des Splitterschutzelements dient

36. Verfahren zum Herstellen einer Anordnung zum Verschließen einer Öffnung eines Fahrzeugs, wobei an einer Scheibe (14) oder an einem an der Scheibe angeordneten Funktionselement (60) ein Splitterschutzelement (30) angebracht wird, und wobei die Scheibe und das Splitterschutzelement mittels einer dauerelastischen Verklebung (12) mit der Fahrzeugkarosserie oder einem mit der Fahrzeugkarosserie verbindbaren Halteelement (18) verbunden werden, **dadurch gekennzeichnet, dass** ein Randbereich (22) des Splitterschutzelements (30) von der Scheibe (14) bzw. dem Funktionselement (60) frei ist und in die Verklebung eintaucht.

37. Verfahren nach Anspruch 36, **dadurch gekennzeichnet, dass** vor der Verklebung die Oberfläche des Splitterschutzelements mit Mitteln (36, 74, 76, 78, 80,84,88,90,92) versehen wird, um die Haftung zwischen dem Splitterschutzelement und der Verklebung zu erhöhen, und dass die Verklebung als Kleberaupe ausgeführt ist.

38. Verfahren zum Herstellen einer Anordnung zum Verschließen einer Öffnung eines Fahrzeugs, wobei an einer Scheibe (14) oder an einem an der Scheibe angeordneten Funktionselement (60) ein Splitterschutzelement (30) angebracht wird, wobei die Scheibe und das Splitterschutzelement mittels einer dauerelastischen Verklebung (12) mit der Fahrzeugkarosserie oder einem mit der Fahrzeugkarosserie verbindbaren Halteelement (18) verbunden werden, **dadurch gekennzeichnet, dass** vor der Verklebung beide Oberflächen des Splitterschutzelements (30) mit einer durch Öffnungen (34) in dem Splittenchutzelement alternierend durchgefädelten, auf beiden Seiten des Splitterschutzelements Ösen (94) bildenden, langgestreckten Struktur (92) versehen werden, um die Haftung zwischen dem Splitterschutzelement und der Verklebung zu erhöhen.

## Claims

1. Arrangement for closing an opening of a vehicle, comprising a pane (14), wherein a shattering protection element (30, 30A, 30B) is fixed to the pane or to a functional element (60) fixed at said pane, and wherein the pane and the shattering protection element are connected via a permanently elastic adhesive connection (12) to the vehicle body or a holding element (18) connected to the vehicle body, **characterized in that** a peripheral region (22, 22A, 22B) of the shattering protection element (30, 30A, 30B) is free from the pane (14) and the functional element (60), respectively, and is immersed in the adhesive connection.

2. Arrangement according to claim 1, **characterized in that** the surface of the shattering protection element is provided with means (36, 74, 76, 78, 80, 84, 88, 90, 92) for increasing the bond between the shattering protection element and the adhesive connection and the adhesive connection (12) is provided as an adhesive band.

3. Arrangement for closing an opening of a vehicle, comprising a pane (14), wherein a shattering protection element (30) is fixed to the pane or to a functional element (60) fixed at said pane, and wherein the pane and the shattering protection element are connected via a permanently elastic adhesive connection (12) to the vehicle body or a holding element (18) connected to the vehicle body, **characterized in that** both surfaces of the shattering protection element (30) are provided with an elongated structure (92) passing alternatingly through openings (34) at both surfaces of the shattering protection element, thereby forming eyelets (94) at both sides of the shattering protection element for increasing the bond between the shattering protection element and the adhesive connection.

4. Arrangement according to any one of claims 1 to 3, **characterized in that** the permanently elastic adhesive connection (12) is provided in a peripheral region (22, 22A, 22B) of the shattering protection element (30, 30A, 30B).

5. Arrangement according to claim 3, **characterized in that** the elongated structure (92) is provided in a peripheral region (22) of the shattering protection element (30).

6. Arrangement according to claim 2, **characterized in that** the means for increasing the bond is a mechanically roughened surface portion (36) of the shattering protection element.

7. Arrangement according to claim 2, **characterized in that** the means for increasing the bond is an elevated structure (76, 80, 88, 90) applied onto the surface of the shattering protection element (30) facing away from the pane (14).

8. Arrangement according to claim 7, **characterized in that** the elevated structure (76, 80, 88, 90) is welded, glued onto or is passed through openings (34) from the side of the shattering protection element (30) facing the pane (14).

9. Arrangement according to claim 7 or 8, **characterized in that** the elevated structure is formed by a profile (76, 78) projecting into the adhesive connection (12) or by single elements (90) projecting into the adhesive connection.

10. Arrangement according to claim 9, **characterized in that** the elevated structure comprises nipples (80) or cones (90) which extend into the adhesive connection (12).

11. Arrangement according to claim 2, **characterized in that** the means for increasing the bond is a structure (84) with a roughened surface which has been applied to the surface of the shattering protection element (30) facing away from the pane.

12. Arrangement according to claim 11, **characterized in that** the structure (84) having the roughened surface has been glued onto the shattering protection element (30) by means of a melting adhesive foil (28, 82).

13. Arrangement according to claim 2, **characterized in that** the means for increasing the bond is a primer system (36) applied to the surface of the shattering protection element (30).

14. Arrangement according to claim 13, **characterized in that** the primer system (36) is enriched by filling particles (74) at the side of the primer system facing away from the shattering protection element (30).

15. Arrangement according to claim 14, **characterized in that** the filling particles (74) are quartz sand or plastic particles.

16. Arrangement according to claim 14 or 15, **characterized in that** the filling particles have an average particle size of 0.1 to 1.0 mm.

17. Arrangement according to any one of the preceding claims, **characterized in that** the shattering protection element (30) is at least in a portion of the holding element (18) between the holding element and the pane (14).

18. Arrangement according to claim 2, **characterized in that** the means (36, 74, 84, 88, 92) for increasing the bond are provided within a peripheral region (22) of the shattering protection element (30).

19. Arrangement according to any one of the preceding claims, **characterized in that** the shattering protection element (30, 30A, 30B) is connected with the adhesive connection (12) in its complete peripheral region or only in parts or segments of its peripheral region.

20. Arrangement according to any one of the preceding claims, **characterized in that** the shattering protection element (30, 30A, 30B) is provided as an elastic foil or a rigid plate.

21. Arrangement according to any one of the preceding claims, **characterized in that** the permanently elastic adhesive connection (12) is provided in a peripheral region of the pane (14).

22. Arrangement according to any one of the preceding claims, **characterized in that** the permanently elastic adhesive connection (12) has a shore A hardness from 30 to 70 and/or a tensile strength of 1 to 10 N/mm² and/or an elongation of tear of 300 to 600 %.

23. Arrangement according to any one of preceding claims 1 to 3, **characterized in that** the adhesive connection (12) is an adhesive band.

24. Arrangement according to any one of the preceding claims, **characterized in that** the functional element is a solar cell composite (60).

25. Arrangement according to any one of preceding claims 1 to 3, **characterized in that** the holding element (18) is a reinforcing frame.

26. Arrangement according to any one of the preceding claims, **characterized in that** the arrangement (10, 110) is a glass panel for a roof opening.

27. Arrangement according to claim 25, **characterized in that** the holding element (18) is an inner roof panel frame.

28. Arrangement according to any one of the preceding claims, **characterized in that** the shattering protection element (30) is fixed to the glass pane (14) or the functional element (60) by means of an adhesive foil (28) or a pressed adhesive layer.

29. Arrangement according to any one of the preceding claims, **characterized in that** the pane (14) is made of safety glass.

30. Arrangement according to claim 18, **characterized in that** the means for increasing the bond is a primer system (36) applied to the surface of the shattering protection element (30) facing the pane (14) or on both surfaces of the shattering protection element.

31. Arrangement according to claim 18, **characterized in that** the means for increasing the bond is an elevated structure (88, 90, 92) applied to the surface of the shattering protection element (30) facing the pane (14) or to both surfaces of the shattering protection element.

32. Arrangement according to claim 31, **characterized in that** the elevated structure is formed by elements (88) which project out of at least one side of the shattering protection element and are plugged through openings (34) provided in the shattering protection element.

33. Arrangement according to claim 32, **characterized in that** the elements that are plugged through is at least one elongated structure (92) threaded alternately through openings (34) in the shattering protection element (30), in particular a yarn or a cord.

34. Arrangement according to claim 33, **characterized in that** the elongated structure (92) forms eyelets (94) at both sides of the shattering protection element (30).

35. Arrangement according to claim 18, **characterized in that** the shattering protection element (30) is connected with the pane by means of a melting adhesive foil (28), wherein the melting adhesive foil extends into the free peripheral region (22) of the shattering protection element (30) and serves to fix the means (84) for increasing the bond at the surface of the shattering protection element facing the pane (14).

36. Method for manufacturing an arrangement for closing an opening of a vehicle, wherein shattering protection element (30) is fixed to a pane (14) or to a functional element (60) fixed to the pane and wherein the pane and the shattering protection element are connected to the vehicle body or to a holding element which is connectable to the vehicle body by means of a permanently elastic adhesive connection (12), **characterized in that** a peripheral region (22) of the shattering protection element (30) is free from the pane (14) or the functional element (60), respectively, and is immersed into the adhesive connection.

37. Method according to claim 36, **characterized in that** prior to the adhesive connection the surface of the shattering protection element is provided with means (36, 74, 76, 78, 80, 84, 88, 90, 92) for improving the bond between the shattering protection element and the adhesive connection and **in that** the adhesive connection is provided as an adhesive band.

38. Method for manufacturing an arrangement for closing an opening of a vehicle, wherein the shattering protection element (30) is fixed to the pane (14) or to a functional element (60) fixed to the pane, wherein the pane and the shattering protection element are connected by means of a permanently elastic adhesive connection (12) to the vehicle body or to a holding element (18) being connectable to the vehicle body, **characterized in that** both surfaces are provided with an elongated structure (92), being alternately plugged through openings (34) in the shattering protection element and forming eyelets (94) on both sides of said shattering protection element for increasing the bond between the shattering protection element and the adhesive connection.

## Revendications

1. Agencement pour fermer une ouverture d'un véhicule, comprenant une vitre (14), dans lequel un élément de protection anti-éclats (30, 30A, 30B) est monté sur la vitre ou sur un élément fonctionnel (60) disposé sur la vitre, et dans lequel la vitre et l'élément de protection anti-éclats sont connectés au moyen d'un collage élastique durable (12) à la carrosserie du véhicule ou à un élément de fixation (18) connecté à la carrosserie du véhicule,
**caractérisé en ce**
**qu'**une région de bord (22, 22A, 22B) de l'élément de protection anti-éclats (30, 30A, 30B) est libre de la vitre (14) ou de l'élément fonctionnel (60) et est enfoncée dans le collage.

2. Agencement selon la revendication 1, **caractérisé en ce que** la surface de l'élément de protection anti-éclats est pourvue de moyens (36, 74, 76, 78, 80, 84, 88, 90, 92) pour accroître l'adhérence entre l'élément de protection anti-éclats et le collage, et **en ce que** le collage (12) est réalisé sous forme de cordon de colle.

3. Agencement pour fermer une ouverture d'un véhicule, comprenant une vitre (14), dans lequel un élément de protection anti-éclats (30) est monté sur la vitre ou sur un élément fonctionnel (60) disposé sur la vitre, dans lequel la vitre et l'élément de protection anti-éclats sont connectés au moyen d'un collage élastique durable (12) à la carrosserie du véhicule ou à un élément de fixation (18) connecté à la carrosserie du véhicule,
**caractérisé en ce que**
les deux surfaces de l'élément de protection anti-éclats (30) sont pourvues d'une structure (92) allongée, formant des oeillets (94) des deux côtés de l'élément de protection anti-éclats, enfilée en alternance à travers des ouvertures (34) dans l'élément de protection anti-éclats, afin d'accroître l'adhérence entre l'élément de protection anti-éclats et le collage.

4. Agencement selon l'une quelconque des revendications 1 à 3, **caractérisé en ce que** le collage élastique durable (12) est prévu dans la région de bord (22, 22A, 22B) de l'élément de protection anti-éclats (30, 30A, 30B).

5. Agencement selon la revendication 3, **caractérisé en ce que** la structure allongée (92) est prévue dans la région de bord (22) de l'élément de protection anti-éclats (30).

6. Agencement selon la revendication 2, **caractérisé en ce que** les moyens pour accroître l'adhérence sont une rugosité de surface (36) réalisée mécaniquement de l'élément de protection anti-éclats.

7. Agencement selon la revendication 2, **caractérisé en ce que** les moyens pour accroître l'adhérence sont une structure rehaussée (76, 80, 88, 90) appliquée sur la surface de l'élément de protection anti-éclats (30) opposée à la vitre (14).

8. Agencement selon la revendication 7, **caractérisé en ce que** la structure rehaussée (76, 80, 88, 90) est soudée, collée ou enfichée à travers des ouvertures (34) depuis le côté de l'élément de protection anti-éclats (30) tourné vers la vitre (14).

9. Agencement selon la revendication 7 ou 8, **caractérisé en ce que** la structure rehaussée est formée par un profil (76, 78) pénétrant dans le collage (12) ou par des éléments individuels (90) pénétrant dans le collage.

10. Agencement selon la revendication 9, **caractérisé en ce que** la structure rehaussée présente des picots (80) ou des cônes (90) pénétrant dans le collage (12).

11. Agencement selon la revendication 2, **caractérisé en ce que** les moyens pour accroître l'adhérence sont une structure (84) avec une surface rugueuse appliquée sur la surface de l'élément de protection anti-éclats (30) opposée à la vitre.

12. Agencement selon la revendication 11, **caractérisé en ce que** la structure (84) avec la surface rugueuse est collée au moyen d'un film de colle fusible (28, 82) sur l'élément de protection anti-éclats (30).

13. Agencement selon la revendication 2, **caractérisé en ce que** les moyens pour accroître l'adhérence sont un système de couche d'apprêt (36) appliqué sur la surface de l'élément de protection anti-éclats (30).

14. Agencement selon la revendication 13, **caractérisé en ce que** le système de couche d'apprêt est enrichi de particules de charge (74) sur le côté du système de couche d'apprêt (36) opposé à l'élément de protection anti-éclats (30).

15. Agencement selon la revendication 14, **caractérisé en ce que** les particules de charge (74) sont du sable de quartz ou des particules de plastique.

16. Agencement selon la revendication 14 ou 15, **caractérisé en ce que** les particules de charge ont une taille de particule moyenne de 0,1 à 1,0 mm.

17. Agencement selon l'une quelconque des revendications précédentes, **caractérisé en ce que** l'élément de protection anti-éclats (30) se situe au moins dans une région partielle de l'élément de fixation (18) entre l'élément de fixation et la vitre (14).

18. Agencement selon la revendication 2, **caractérisé en ce que** des moyens ou les moyens (36, 74, 84, 88, 92) pour accroître l'adhérence sont prévus dans la région de bord libre (22) de l'élément de protection anti-éclats (30).

19. Agencement selon l'une quelconque des revendications précédentes, **caractérisé en ce que** l'élément de protection anti-éclats (30, 30A, 30B) est connecté au collage (12) dans sa région de bord périphérique complète ou seulement dans des parties ou des segments de sa région de bord périphérique.

20. Agencement selon l'une quelconque des revendications précédentes, **caractérisé en ce que** l'élément de protection anti-éclats (30, 30A, 30B) est réalisé sous forme de film élastique ou de plaque rigide.

21. Agencement selon l'une quelconque des revendications précédentes, **caractérisé en ce que** le collage élastique durable (12) est prévu dans la région de bord de la vitre (14).

22. Agencement selon l'une quelconque des revendications précédentes, **caractérisé en ce que** le collage élastique durable (12) présente une dureté Shore A de 30 à 70 et/ou une résistance à la traction de 1 à 10 N/mm² et/ou une élongation à la rupture de 300 à 600 %.

23. Agencement selon l'une quelconque des revendications précédentes 1 ou 3, **caractérisé en ce que** le collage (12) est réalisé sous forme de cordon de colle.

24. Agencement selon l'une quelconque des revendications précédentes, **caractérisé en ce que** l'élément fonctionnel est un composite de cellules solaires (60).

25. Agencement selon l'une quelconque des revendications précédentes 1 ou 3, **caractérisé en ce que** l'élément de fixation (18) est un cadre de renfort.

26. Agencement selon l'une quelconque des revendications précédentes, **caractérisé en ce que** l'agencement (10, 110) forme un recouvrement en verre pour une ouverture du toit.

27. Agencement selon la revendication 25, **caractérisé en ce que** l'élément de fixation (18) est une tôle intérieure de recouvrement.

28. Agencement selon l'une quelconque des revendications précédentes, **caractérisé en ce que** l'élément de protection anti-éclats (30) est appliqué au moyen d'un film de colle (28) ou d'une couche d'adhésif pressée sur la vitre en verre (14) ou sur l'élément fonctionnel (60).

29. Agencement selon l'une quelconque des revendications précédentes, **caractérisé en ce que** la vitre (14) est fabriquée en verre de sécurité.

30. Agencement selon la revendication 18, **caractérisé en ce que** les moyens pour accroître l'adhérence sont un système de couche d'apprêt (36) appliqué sur la surface de l'élément de protection anti-éclats (30) tournée vers la vitre (14) ou sur les deux surfaces de l'élément de protection anti-éclats.

31. Agencement selon la revendication 18, **caractérisé en ce que** les moyens pour accroître l'adhérence sont une structure rehaussée (88, 90, 92) appliquée sur la surface de l'élément de protection anti-éclats (30) tournée vers la vitre (14) ou sur les deux surfaces de l'élément de protection anti-éclats.

32. Agencement selon la revendication 31, **caractérisé en ce que** la structure rehaussée est formée par des éléments (88) enfichés à travers des ouvertures (34) dans l'élément de protection anti-éclats (30) et saillant sur au moins un côté de l'élément de protection anti-éclats.

33. Agencement selon la revendication 32, **caractérisé en ce que** les éléments enfichés sont au moins une structure allongée (92), en particulier un fil ou un cordon, enfilée en alternance à travers des ouvertures (34) dans l'élément de protection anti-éclats (30).

34. Agencement selon la revendication 33, **caractérisé en ce que** la structure allongée (92) forme des oeillets (94) des deux côtés de l'élément de protection anti-éclats (30).

35. Agencement selon la revendication 18, **caractérisé en ce que** l'élément de protection anti-éclats (30) est connecté à la vitre au moyen d'un film de colle fusible (28), le film de colle fusible s'étendant dans la région de bord libre (22) de l'élément de protection anti-éclats (30) et servant à appliquer les moyens (84) pour accroître l'adhérence à la surface de l'élément de protection anti-éclats tournée vers la vitre (14).

36. Procédé de fabrication d'un agencement pour fermer une ouverture d'un véhicule, dans lequel un élément de protection anti-éclats (30) est appliqué sur une vitre (14) ou sur un élément fonctionnel (60) disposé sur la vitre, et dans lequel la vitre et l'élément de protection anti-éclats sont connectés au moyen d'un collage élastique durable (12) à la carrosserie du véhicule ou à un élément de fixation (18) pouvant être connecté à la carrosserie du véhicule, **caractérisé en ce qu'**une région de bord (22) de l'élément de protection anti-éclats (30) est libre de la vitre (14) ou de l'élément fonctionnel (60) et est enfoncée dans le collage.

37. Procédé selon la revendication 36, **caractérisé en ce qu'**avant le collage, la surface de l'élément de protection anti-éclats est munie de moyens (36, 74, 76, 78, 80, 84, 88, 90, 92) pour accroître l'adhérence entre l'élément de protection anti-éclats et le collage, et **en ce que** le collage (12) est réalisé sous forme de cordon de colle.

38. Procédé de fabrication d'un agencement pour fermer une ouverture d'un véhicule, dans lequel un élément de protection anti-éclats (30) est monté sur la vitre ou sur un élément fonctionnel (60) disposé sur la vitre, la vitre et l'élément de protection anti-éclats étant connectés au moyen d'un collage élastique durable (12) à la carrosserie du véhicule ou à un élément de fixation (18) pouvant être connecté à la carrosserie du véhicule, **caractérisé en ce qu'**avant le collage, les deux surfaces de l'élément de protection anti-éclats sont munies d'une structure allongée (92), formant des oeillets (94) des deux côtés de l'élément de protection anti-éclats, enfilée en alternance à travers des ouvertures (34) dans l'élément de protection anti-éclats, afin d'accroître l'adhérence entre l'élément de protection anti-éclats et le collage.
